# EUROPÄISCHE PATENTSCHRIFT

(11) **EP 2 928 280 B1**
(45) Veröffentlichungstag und Bekanntmachung des Hinweises auf die Patenterteilung: **08.05.2019**
(21) Anmeldenummer: 15158645.0
(22) Anmeldetag: 11.03.2015
(51) Int. Cl.: H05K 13/08

(54) **MESSMARKENSYSTEM ZUR KALIBRIERUNG EINER MASCHINE**
MEASURING MARK SYSTEM FOR CALIBRATING A MACHINE
SYSTÈME DE REPÈRE POUR L'ÉTALONNAGE D'UNE MACHINE

(30) Priorität: 31.03.2014 DE 102014104523
(43) Veröffentlichungstag der Anmeldung: 07.10.2015
(73) Patentinhaber: Dr. Johannes Heidenhain GmbH, 83301 Traunreut (DE)
(72) Erfinder: Holzapfel, Wolfgang, 83119 Obing (DE); Frese, Daniel, 83278 Traunstein (DE); Höfer, Volker, 83349 Palling (DE); Spanner, Erwin, 83278 Traunstein (DE)

(56) Entgegenhaltungen:
- EP-A2- 1 881 753
- WO-A1-2004/039139
- WO-A1-2004/064472
- DE-A1-102009 016 473
- US-A1- 2004 026 006

## Beschreibung

Die Erfindung betrifft ein Messmarkensystem zur Kalibrierung einer Maschine nach dem Oberbegriff des Anspruchs 1.

Hierbei geht es um die Kalibrierung einer Maschine, die einen im Betrieb entlang mindestens einer Raumrichtung verfahrbaren und mittels einer zugeordneten Positioniereinrichtung positionierbaren Maschinenkopf aufweist. Ein Beispiel für eine derartige Maschine ist eine Vorrichtung zum Bestücken von Substraten mit Bauelementen, die auch als "Bestückungsmaschine" bzw. "Bestückungsautomat" bezeichnet wird. Bei derartigen Maschinen, in deren Betrieb eine hochgenaue Positionierung des Maschinenkopfes, wie z. B. eines Bestückungskopfes, von großer Bedeutung ist, werden Kalibrierverfahren genutzt, um eine angestrebte Präzision bei der Positionierung sicherzustellen.

Hierfür kann das zur Kalibrierung verwendete Messmarkensystem mindestens eine Messmarke aufweisen, die bestimmungsgemäß an der zu kalibrierenden Maschine angebracht wird; weiterhin ist eine Abtasteinheit zur Erfassung der Messmarke(n) vorgesehen, die bestimmungsgemäß derart an der Maschine angeordnet wird, dass sie gemeinsam mit deren Maschinenkopf relativ zu der Messmarke bzw. den Messmarken verfahrbar ist.

Aus der DE 103 00 518 A1 sind ein Verfahren zum Kalibrieren eines Bestückungsautomaten sowie eine zur Durchführung des genannten Verfahrens eingerichtete Vorrichtung bekannt. Dabei wird mittels einer zum Aufnehmen von Substratmarkierungen vorgesehenen Kamera zusätzlich eine Mehrzahl am Bestückungsbereich der Vorrichtung in unterschiedlichen Positionen angebrachter Kalibriermarkierungen erfasst, um deren relative Lage zur Position der Kamera zu bestimmen und auf dieser Grundlage die Vorrichtung zu kalibrieren (indem jene Relativlage für einen jeweiligen Bestückvorgang berücksichtigt wird).

Mit einem Messmarkensystem der eingangs genannten Art lässt sich eine Maschine mit verfahrbarem Maschinenkopf z.B. vor ihrer ersten Inbetriebnahme kalibrieren, um Fertigungsungenauigkeiten auszugleichen. Im Betrieb der Maschine können jedoch zusätzliche Ungenauigkeiten durch Umwelteinflüsse, wie z.B. Temperaturschwankungen und insbesondere einer "temperaturbedingten Drift", hervorgerufen werden.

Bei einer angestrebten Kalibrierung einer Maschine nicht nur vor deren erster Inbetriebnahme (zur Kompensation von Fertigungsungenauigkeiten) sondern auch während des Betriebs, etwa zur Berücksichtigung von Temperaturschwankungen, kann die Schwierigkeit auftreten, dass eine jeweilige Messmarke, die für eine Erfassung mittels einer in die Maschine eingebauten Kamera positioniert ist, mit den im Betrieb der Maschine zu bewegenden Teilen kollidieren würde.

Die EP 1 881 753 A2, von der bei der Bildung des Oberbegriffs von Anspruch 1 ausgegangen wurde, offenbart ein Verfahren zur Bestimmung der Orientierung einer Kamera relativ zu einer Referenzebene, das in einem Bestückungsautomaten eingesetzt werden kann. Hierbei wird mittels der Kamera eine optische Verschiebung einer in einer Referenzebene ausgebildeten Referenzstruktur erfasst, wobei die Verschiebung durch ein refraktives optisches Element zwischen Kamera und Referenzstruktur verursacht wird. Aus der ermittelten Verschiebung kann die Orientierung der Kamera relativ zur Referenzebene bestimmt werden.

Aus der WO 2004/039139 A1 ist ein weiteres Verfahren zur Bestimmung der relativen räumlichen Lage zwischen zwei Kameras in einem Bestückungsautomaten bekannt. Hierbei wird ein Sensor einer ersten Kamera durch eine Dunkelfeld- und/oder eine Hellfeld-Beleuchtung beleuchtet, so dass aufgrund der Umkehrbarkeit der Strahlengänge in der Objektebene ein reelles Zwischenbild des Kamerasensors erzeugt wird. Die zweite Kamera wird so angeordnet, dass dieses Zwischenbild damit aufgenommen und so der räumliche Zusammenhang zwischen den beiden Kameras bestimmbar ist.

Die WO 2004/064472 A1 offenbart ein Verfahren zur präzisen Bestimmung der Relativposition eines Bauteils zu einem Greiferelement in einem Bestückungsautomaten. Hierzu wird mittels einer Kamera und einer Abbildungsoptik ein Markierungselement am Bauteil erfasst und gleichzeitig mit dem Bauelement in einem Bild dargestellt.

Der Erfindung liegt daher das Problem zugrunde, ein Messmarkensystem zur Kalibrierung einer Maschine zur Verfügung zu stellen, das die vorgenannten Nachteile vermeidet.

Dieses Problem wird erfindungsgemäß durch die Schaffung eines Messmarkensystems mit den Merkmalen des Anspruchs 1 gelöst.

Danach ist bei einem gattungsgemäßen Messmarkensystem der Messmarke bzw. den Messmarken eine Abbildungsoptik zugeordnet, mittels der unter Wechselwirkung von der Abtasteinheit erzeugter elektromagnetischer Strahlung mit der mindestens einen Messmarke eine virtuelle Messmarke in einer von der Messmarke beabstandeten Abbildungsebene erzeugt wird, wobei die zur Erfassung der Messmarke(n) vorgesehene Abtasteinheit dazu eingerichtet ist, die virtuelle Messmarke(n) optisch abzutasten, d.h. deren Position relativ zum Maschinenkopf zu erfassen.

Hierdurch ist es nicht mehr erforderlich, die (realen, als dauerhafte Struktur vorliegenden) Messmarke(n) selbst in der Ebene anzuordnen, auf welche die in eine Maschine eingebaute Abtasteinheit fokussiert ist und die regelmäßig der Bearbeitungsebene entspricht; sondern eine jeweilige Messmarke selbst kann hiervon beabstandet angebracht werden, weil lediglich die durch Abbildung einer jeweiligen Messmarke erzeugte virtuelle Messmarke tatsächlich abzutasten ist.

Die Abtasteinheit des Messmarkensystems weist eine elektromagnetische Strahlungsquelle zur Bestrahlung der (realen) Messmarke(n) auf sowie eine Detektoranordnung zur Detektion der virtuellen Messmarke(n). Hierbei kann die Strahlungsquelle gemäß einer Ausführungsform zeitlich getaktet betrieben werden. D. h., die Strahlungsquelle wird für eine jeweilige Positionsmessung (zu Zwecken der Kalibrierung) ein- und anschließend wieder ausgeschaltet, um den Betrieb der zugeordneten Maschine nicht zu beeinträchtigen. Die Positionsmessungen anhand des Messmarkensystems werden sonach jeweils nur in bestimmten Zeitfenstern (Kalibrierphasen) ausgeführt, und (nur) in diesen ist auch die zugehörige Strahlungsquelle in Betrieb.

Als Strahlungsquelle kann dabei eine Diode (LED) oder ein Laser verwendet werden. Des Weiteren können eine Messmarke oder mehrere Messmarken vorgesehen sein, die an der zugeordneten Maschine anzuordnen sind.

Die zur Erfassung der virtuellen Messmarke(n) vorgesehene Detektoranordnung kann in einfacher Weise eine Kamera umfassen, welche ein Bestandteil der zur Positionierung eines Maschinenkopfes vorgesehenen Positioniereinrichtung bildet und dementsprechend auch im Normalbetrieb der Maschine, also außerhalb von Kalibrierphasen, verwendet wird.

Die Abbildungsoptik, mittels welcher die Messmarke(n) des Messmarkensystems unter Erzeugung mindestens einer virtuellen Messmarke auf eine Abbildungsebene abgebildet werden, umfasst ein der Strahlungsquelle nachgeordnetes und der mindestens einen Messmarke vorgelagertes Sendegitter. Eine jeweilige virtuelle Messmarke wird dann in Form einer Selbstabbildung des Sendegitters erzeugt. Hierbei ist der (die optische Weglänge der von der Strahlungsquelle ausgesandten elektromagnetischen Strahlung berücksichtigende) effektive Abstand zwischen dem Sendegitter und der mindestens einen Messmarke vorteilhaft gleich dem effektiven Abstand zwischen jener mindestens einen Messmarke und der/den hieraus erzeugten virtuellen Messmarke(n).

Gemäß einer Ausgestaltung der Erfindung verläuft eine Strahlungsachse der von der Strahlungsquelle in Richtung auf die Messmarke(n) ausgesandten Strahlung parallel zu der Abbildungsachse, entlang welcher die virtuelle(n) Messmarke(n) auf die Detektoranordnung abgebildet wird. Nach einer Variante sind die Strahlungsachse und die Abbildungsachse dabei voneinander beabstandet. Nach einer anderen Variante fallen die Strahlungsachse und die Abbildungsachse demgegenüber zusammen; d. h., sie verlaufen kollinear.

Die mindestens eine Messmarke erstreckt sich bevorzugt entlang einer Messmarkenebene, die parallel zu der Abbildungsebene verläuft, in welcher die mindestens eine virtuelle Messmarke vorgesehen ist. Die Strahlungsachse und die Abbildungsachse können in diesem Fall insbesondere senkrecht zu der Messmarkenebene und der Abbildungsebene ausgerichtet sein.

Weiterhin kann vorgesehen sein, dass es sich bei der in Richtung auf die Messmarke(n) ausgesandten Strahlung um ein kollimiertes (parallelisiertes) Strahlenbündel handelt.

Die mindestens eine Messmarke kann durch die Abtasteinheit z.B. im Auflichtverfahren abgetastet werden, sodass die Strahlungsquelle und die Detektoranordnung der Abtasteinheit vor derselben Seite der Messmarke(n) angeordnet sind. Hierfür kann die mindestens eine Messmarke auf einem reflektierenden Substrat angeordnet sein. Dementsprechend wird die von der Strahlungsquelle ausgesandte und mit der mindestens einen Messmarke wechselwirkende elektromagnetische Strahlung zur Erzeugung der (von der Detektoranordnung zu erfassenden) virtuellen Messmarke von dem Substrat zurückgeworfen. Hierbei können ferner Umlenkmittel zur Umlenkung der von der Strahlungsquelle erzeugten elektromagnetischen Strahlung vorgesehen sein, sodass diese parallel (und dabei gegebenenfalls kollinear) zu der Abbildungsachse der Detektoranordnung verläuft.

Nach einer alternativen Ausgestaltung der Abtastung im Auflichtverfahren ist die mindestens eine Messmarke des Messmarkensystems auf einem strahlungsdurchlässigen Substrat vorgesehen. In diesem Fall kann das Substrat abschnittsweise verspiegelt sein, um die von der Strahlungsquelle ausgesandte elektromagnetische Strahlung nach der Wechselwirkung mit der Messmarke zu reflektieren und diese so weiterzuleiten, dass sie im Ergebnis von der zugeordneten Detektoranordnung vor dem Substrat detektierbar ist. Hierbei kann an dem Substrat insbesondere ein Umlenkgitter zum Einkoppeln elektromagnetischer Strahlung in das Substrat und/oder ein Umlenkgitter zum Auskoppeln elektromagnetischer Strahlung aus dem Substrat vorgesehen sein, um aus der elektromagnetischen Strahlung nach Wechselwirkung mit der mindestens einen Messmarke die entsprechende(n) virtuelle(n) Messmarke(n) zu erzeugen.

Eine jeweilige Messmarke weist für eine hochgenaue Positionsbestimmung und daraus abgeleitete Kalibrierung zumindest abschnittsweise eine Gitterstruktur auf, wobei diese als Phasengitter, als Amplitudengitter oder als gemischte Amplituden- und Phasenstruktur ausgebildet sein kann.

Nach einer Weiterbildung können für eine absolute Positionsbestimmung an einer jeweiligen Messmarke zwei oder mehr Gitterstrukturen vorgesehen sein, die sich entlang derselben Raumrichtung (mit einer jeweiligen Gitterstrichrichtung senkrecht zu der Richtung, entlang der eine Kalibrierung erfolgen soll) erstrecken und die eine unterschiedliche Gitterkonstante aufweisen.

Für eine Positionsbestimmung/Kalibrierung entlang unterschiedlicher Raumrichtungen können mindestens zwei Gitterstrukturen an einer jeweiligen Messmarke vorgesehen sein, die sich entlang verschiedener Raumrichtungen erstrecken.

Weitere Einzelheiten und Vorteile der Erfindung werden bei nachfolgender Beschreibung von Ausführungsbeispielen anhand der Figuren deutlich werden.

Es zeigen:
- Fig. 1: ein Ausführungsbeispiel eines Messmarkensystems zur Kalibrierung einer Maschine;
- Fig. 2: eine erste Abwandlung des Messmarkensystems aus Figur 1;
- Fig. 3: eine zweite Abwandlung des Messmarkensystems aus Figur 1;
- Fig. 4A: eine mögliche Ausgestaltung einer Messmarke für ein Messmarkensystem gemäß einer der Figuren 1 bis 3;
- Fig. 4B: eine Abwandlung der Messmarke aus Figur 4A;
- Fig. 5: eine weitere Abwandlung der Messmarke aus Figur 4A;
- Fig. 6A: ein Sendegitter für das Messmarkensystem aus Figur 1;
- Fig. 6B: zwei Umlenkgitter für das Messmarkensystem aus Figur 1, von denen eines mit einem Messmarkengitter kombiniert ist;
- Fig. 6C: ein bei dem Messmarkensystem gemäß Figur 1 resultierendes Selbstabbildungsgitter;
- Fig. 7A: ein Sendegitter für das Messmarkensystem aus Figur 2;
- Fig. 7B: ein Messmarkengitter für das Messmarkensystem aus Figur 2;
- Fig. 7C: ein beim Messmarkensystem der Figur 2 resultierendes Selbstabbildungsgitter,
- Fig. 8: eine Maschine in Form eines Bestückungsautomaten, bei der ein Messmarkensystem zur Kalibrierung einsetzbar ist.

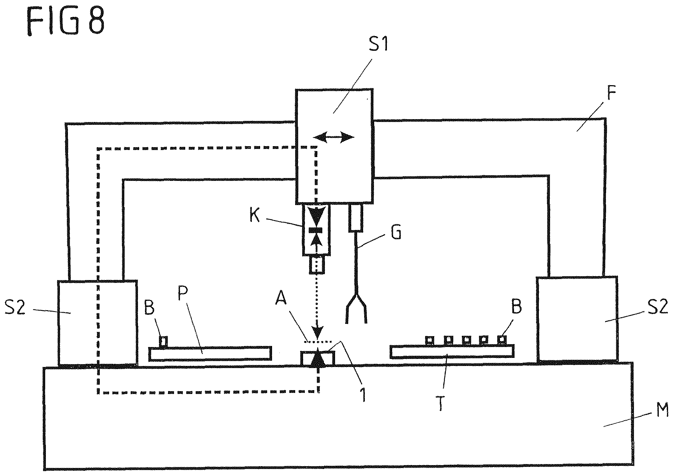

Figur 8 zeigt schematisch eine Maschine zum Bestücken von Platinen mit elektrischen bzw. elektronischen Bauteilen. Die Maschine umfasst ein Maschinenbett M sowie eine Schlittenführung F, an der einerseits ein Schlitten S1 entlang einer ersten Richtung beweglich geführt ist und an der andererseits Schlitten S2 entlang einer hiervon verschiedenen zweiten (senkrechten) Richtung beweglich geführt sind. Die Schlitten S1, S2 weisen jeweils ein Messsystem zur Positionsbestimmung (Positionsmesseinrichtung) auf.

Zumindest ein Schlitten S1 trägt zudem einen Greifer G, mit dem Bauteile B von einem am Maschinenbett M angeordneten Träger T abnehmbar und einer ebenfalls am Maschinenbett M angeordneten, zu bestückenden Platine P zuführbar sind. An jenem Schlitten S1 ist weiterhin eine Kamera K angeordnet, die im Betrieb der Maschine z.B. für Positionsbestimmungen der Bauteile B genutzt wird.

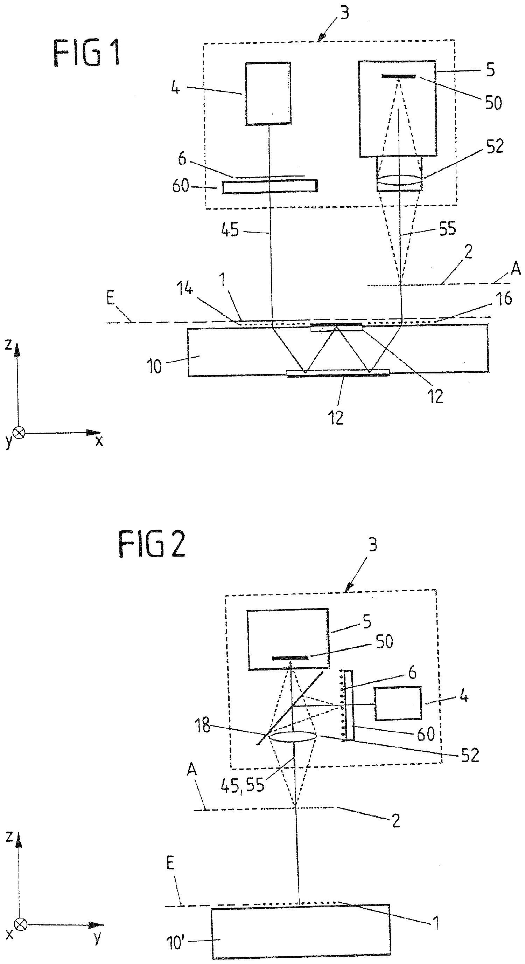

Wie nachfolgend anhand der Figuren 1 bis 7C beschrieben werden wird, kann die Kamera K in einer Doppelnutzung weiterhin dazu dienen, die Maschine unter Verwendung eines Messmarkensystems zu kalibrieren, wobei hierfür alternativ aber auch eine von der Kamera separate Detektoranordnung genutzt werden kann. Gemäß Figur 8 ist hierzu eine Messmarke 1 am Maschinenbett M vorgesehen. Die Messmarke 1 befindet sich außerhalb der Ebene, in welcher die Bauteile B von dem Träger T abzunehmen sind bzw. auf die Platine P aufzusetzen sind (Bearbeitungsebene). Hierdurch wird die Gefahr von Kollisionen im Betrieb der Maschine reduziert. Jedoch kann so nicht sichergestellt werden, dass die Messmarke 1 in einer Ebene liegt, auf welche die Kamera K im Betrieb der Maschine fokussiert ist.

Daher wird vorliegend bei einer Kalibrierung der Maschine nicht die Messmarke 1 selbst durch die Kamera abgetastet, sondern vielmehr eine virtuelle Messmarke in einer in Figur 8 schematisch angedeuteten Abbildungsebene A, auf welche die Kamera bestimmungsgemäß fokussiert ist. Auch das Vorgehen bei der Erzeugung einer entsprechenden virtuellen Messmarke wird nachfolgend anhand der Figuren 1 bis 7C im Einzelnen beschrieben werden.

Mittels der nachfolgend erläuterten Lösung wird in der Maschine gemäß Figur 8 ein sehr kurzer Messzirkel zwischen der Kamera K und der Messmarke 1 gebildet, was durch die punktiert dargestellte Verbindungslinie veranschaulicht werden soll. Der demgegenüber aus einem Vorgehen gemäß dem Stand der Technik resultierende, deutlich längere Messzirkel ist in Figur 8 durch eine gestrichelte Verbindungslinie repräsentiert. Wie ersichtlich, resultiert in diesem Fall ein mechanischer Umweg, über den der Messwert des Positionsmesssystems im Schlitten S1 auf die Bearbeitungsebene übertragen wird. Bedingt durch Führungsungenauigkeiten und mechanische Deformationen der Führungsstruktur kommt es dabei aufgrund des sehr großen Abbe-Abstandes zwischen dem Positionsmesssystem im Schlitten S1 und der Bearbeitungsebene zu erheblichen Messfehlern. Über die hier vorgeschlagene Lösung mit einem resultierenden verkürzten bzw. kurzgeschlossenen Messzirkel kann ein derartiger Messfehler durch die Detektion der Phasenverschiebung des virtuellen Bildes eines Sendegitters erfasst werden. Mit Hilfe eines derart detektierten Messfehlers kann dann der erzeugte Messwert des Positionsmesssystems im Schlitten S1 korrigiert werden. Als maßgeblicher Vorteil resultiert damit eine deutlich genauere Kompensation bzw. Korrektur des Messwerts des Positionsmesssystems im Schlitten S1. Wie nachfolgend erläutert werden wird, wird hierbei auf das virtuelle Gitter in der Bearbeitungsebene referenziert, während im Stand der Technik auf eine Messmarke auf der Oberfläche des Maschinenbetts referenziert wird, welche einen Abstand zur Bearbeitungsfläche aufweist.

Grundgedanke des nachfolgend anhand der Figuren 1 bis 7C zu beschreibenden Messmarkensystems ist die Überwindung der vorstehend anhand Figur 8 beschriebenen Problematik einer möglichen Kollision bewegter Teile der Maschine mit der Messmarke. Hierzu wird gemäß den Ausführungsbeispielen unter Verwendung (mindestens) zweier realer Gitter, welche außerhalb des kollisionsgefährdeten Raumes der Maschine liegen, eine Selbstabbildung eines der Gitter (Sendegitter) innerhalb des kollisionsgefährdeten Raumes erzeugt, und zwar gerade in einer Abbildungsebene, auf welche die Kamera fokussiert ist, wobei letztere die Abbildung des Sendegitters in gleicher Weise detektieren kann wie ein reales Sendegitter. Die Gefahr einer Kollision bewegter Teile mit einem Abbild eines Gitters, also mit einer virtuellen Messmarke, besteht selbstverständlich nicht.

Bei einem derartigen Messmarkensystem ist es vorteilhaft, wenn die Detektion der virtuellen Messmarke mittels einer zugeordneten Detektoranordnung, z. B. einer Kamera der betreffenden Maschine, an welcher das Messmarkensystem angeordnet ist, unabhängig vom Abstand der Detektoranordnung zur Ebene der realen Messmarke ist, die vorliegend als ein das Sendegitter ergänzendes zweites Gitter ausgebildet ist. Dies lässt sich erreichen, indem die Achse der elektromagnetischen Strahlung (insbesondere Licht), mittels der die Gitter bestrahlt (beleuchtet) werden, d.h. die Strahlungsachse, parallel zu der Abbildungsachse der zugehörigen Detektoranordnung ist. Weiterhin sollten jene Achsen im Wesentlichen senkrecht zu den Ebenen verlaufen, in welchen sich die beiden genannten Gitter, nämlich ein Sendegitter als erstes Gitter und mindestens eine Messmarke als zweites Gitter, erstrecken.

Nach einer Ausführungsform können dabei die Strahlungsachse und die Abbildungsachse der Detektoranordnung voneinander beabstandet sein, wobei die Strahlungs- und die Abbildungsachse sowohl senkrecht wie auch parallel bezüglich der Messrichtung orientiert sein können. Dies bedingt einen Parallelversatz des selbstabgebildeten Gitters (also der virtuellen Messmarke(n)) von der Strahlungsachse in die Abbildungsachse der Detektoranordnung. Nach einer anderen Ausführungsform können die beiden vorgenannten Achsen kollinear ausgebildet sein, also räumlich zusammenfallen.

Weiterhin ist bei der Erfassung der Messmarke(n) die Verwendung eines Auflichtprinzips vorteilhaft, bei welchem eine Selbstabbildung des Sendegitters, also die jeweilige virtuelle Messmarke, in einem Raum zwischen der (realen) Messmarke und der Detektoranordnung erzeugt wird. Bei einer Abstandsänderung zwischen der Detektoranordnung und der Messmarke ergeben sich dann immer gleiche Abstände zwischen den beiden Gittern (also zwischen dem Sendegitter als erstem Gitter und der Messmarke als zweitem Gitter) sowie zwischen der Messmarke und der Abbildungsebene, in welcher die virtuelle Messmarke erzeugt wird. Der erstgenannte Abstand wird nachfolgend auch mit u bezeichnet, und der zweitgenannte mit v, wobei hier jedoch effektive Abstände unter Berücksichtigung des optischen Weges zugrunde gelegt werden, wie nachfolgend näher erläutert werden wird.

Im Ergebnis bleiben mit den vorgenannten Maßnahmen das Abbildungsverhältnis für die Selbstabbildung und damit deren Periode (unabhängig davon, ob die zur Abtastung der Messmarke verwendete Strahlung gegebenenfalls kollimiert ist) bei einer Abstandsänderung zwischen der Detektoranordnung und der Messmarke konstant.

Soweit hier von der Erfassung einer Messmarke gesprochen wird, bezieht sich dies erfindungsgemäß auf einen Vorgang, gemäß dem eine elektromagnetische Strahlungsquelle einer Abtasteinheit des Messmarkensystems elektromagnetische Strahlung erzeugt, welche auf ein Sendegitter sowie auf mindestens eine (reale) Messmarke auftrifft, und dass hierbei in einer Abbildungsebene (als Selbstabbildung des Sendegitters) mindestens eine virtuelle Messmarke erzeugt wird, die wiederum von einer Detektoranordnung der Abtasteinheit abgetastet wird.

Die für die nachfolgend beschriebenen Messmarkensysteme relevante Selbstabbildung von Gittern lässt sich nach einer Theorie von Pettigrew beschreiben, vergleiche R. M. Pettigrew, Analysis of Grating Imaging and its Application to Displacement Metrology, 1st European Congress on Optics Applied to Metrology, SPIE Vol. 136 (1977).

Bei der Selbstabbildung werden der Fall des geometrischen Bildes und der Fall des Beugungsbildes unterschieden. Im Fall des geometrischen Bildes ist die Selbstabbildung nur in periodischen Abständen von der Messmarke erzeugbar; d. h., es lässt sich keine vollständige Abstandsunabhängigkeit erreichen. Bei festen Detektionsebenen hat man hier den Vorteil eines hohen Kontrastes. Die Gitterstrukturen der Messmarke werden zweifach vergrößert abgebildet.

Bei einer Selbstabbildung im Beugungsbild gibt es demgegenüber keine periodischen Abstandsbedingungen, d.h. es liegt eine Abstandsunabhängigkeit vor. Die Gitterstrukturen der Messmarke werden unvergrößert abgebildet.

Die Beleuchtung kann sowohl mit divergenter als auch mit kollimierter (parallelisierter) Strahlung erfolgen. Die Ausführung mit kollimierter Beleuchtung ist hier vorteilhaft aufgrund einer größeren Signalstärke und besseren Abstandstoleranzen. Zudem ist die Variation der abgebildeten Teilungsperiode aufgrund von Änderungen der optischen Weglängen, die durch Fertigungstoleranzen bedingt werden, im kollimierten Fall kleiner.

Sind die effektiven Abstände zwischen Sendegitter und Messmarke einerseits sowie zwischen Messmarke und virtueller Messmarke (Selbstabbildung des Sendegitters) andererseits gleich groß (u/v = 1), so ist die Periode der in der Abbildungsebene erzeugten Selbstabbildung des Sendegitters genauso groß wie diejenige des Sendegitters.

Figur 1 zeigt ein Messmarkensystem, dass in einer Maschine der in Figur 8 schematisch dargestellten Art, also insbesondere in einem Bestückungsautomaten, verwendbar ist.

Das Messmarkensystem umfasst mindestens eine (reale) Messmarke 1, die sich in einer Messmarkenebene E erstreckt und die auf einem Substrat 10 angeordnet ist. Bei dem Substrat 10 handelt es sich vorliegend um ein für die zur Abtastung der Messmarke(n) verwendete elektromagnetische Strahlung durchlässiges Substrat. Dieses weist an seinen Oberflächen Spiegelschichten 12 auf, so dass sich die elektromagnetische Strahlung innerhalb des Substrates 10 unter Reflexion an den Spiegelschichten 12 fortpflanzen kann.

Zum Einkoppeln elektromagnetischer Strahlung in das Substrat 10 (im Ausführungsbeispiel nach deren Wechselwirkung mit der Messmarke 1) ist ein Umlenkgitter 14 vorgesehen. Das zur Einkopplung elektromagnetischer Strahlung dienende Umlenkgitter 14 liegt im Ausführungsbeispiel der Figur 1 an der der Messmarke 1 zugewandten Oberfläche des Substrates 10. Die Messmarke 1 und das eingangsseitige Umlenkgitter 14 sind somit im Ausführungsbeispiel an einer Oberfläche des Substrates 10 zusammengefasst. Eine solche Anordnung ist jedoch keineswegs zwingend; alternativ kann etwa ein separates Substrat zur Aufnahme der Messmarke 1 dienen. Weiterhin ist ein zweites Umlenkgitter 16 zur Auskopplung elektromagnetischer Strahlung aus dem Substrat 10 vorgesehen. Die beiden Umlenkgitter 14, 16 sind dabei voneinander beabstandet, und zwar entlang einer Richtung x, welche quer zur Messrichtung y verläuft, entlang welcher die Messmarke 1 für eine Kalibrierung abzutasten ist.

Der mindestens einen auf dem Substrat 10 in einer Ebene E angeordneten Messmarke 1 ist eine Abtasteinheit 3 zugeordnet, welche eine Strahlungsquelle 4 sowie eine Detektoranordnung 5 umfasst. Die Strahlungsquelle 4 erzeugt eine elektromagnetische Strahlung, insbesondere in Form von Licht. Im Ausführungsbeispiel handelt es sich dabei um eine Strahlungsquelle, die eine kollimierte (parallelisierte) elektromagnetische Strahlung abgibt. Der Strahlungsquelle 4 ist ein (auf einem Gittersubstrat 60 angeordnetes) Sendegitter 6 nachgeordnet, welches ebenfalls einen Bestandteil der Abtasteinheit 3 bildet und somit zusammen mit der Strahlungsquelle 4 und der Detektoranordnung 5 (zumindest entlang der y-Richtung) relativ zu der Messmarke 1 bewegbar ist.

Das Sendegitter 6 ist dabei derart hinter der Strahlungsquelle 4 der Abtasteinheit 3 angeordnet, dass die von der Strahlungsquelle 4 ausgesandte elektromagnetische Strahlung 45 zunächst das Sendegitter 6 passiert und mit diesem wechselwirkt, bevor sie auf die Messmarke 1 auftrifft.

Durch die Wechselwirkung der von der Strahlungsquelle 4 erzeugten elektromagnetischen Strahlung mit dem Sendegitter 6 und der mindestens einen Messmarke 1 wird in der Abbildungsebene A der Detektoranordnung 5, bei der es sich insbesondere um eine Kamera mit einem Sensorchip 50 sowie einem vorgelagerten Objektiv 52 handeln kann, mindestens eine virtuelle Messmarke 2 erzeugt. Diese ist aufgrund der abschnittsweisen Fortleitung der elektromagnetischen Strahlung in dem Substrat 10 relativ zu jener Messmarke 1 versetzt, und zwar senkrecht zu der Richtung z, entlang welcher die von der Strahlungsquelle 4 erzeugte elektromagnetische Strahlung entlang einer Strahlungsachse 45 der Messmarke 1 zugeführt wird.

Weiterhin ist die virtuelle Messmarke 2 gegenüber der Messmarke 1 auch entlang jener Strahlungsachse 45 beabstandet, und zwar derart, dass sie in einer Abbildungsebene A liegt, auf welche die Detektoranordnung 5 fokussiert ist. Dies ist durch axiale Positionierung des Sendegitters 6, also durch dessen Positionierung entlang der Strahlungsachse 45, einstellbar. Die Abbildungsebene A , in die das Sendegitter 6 zur Erzeugung mindestens einer virtuellen Messmarke 2 abgebildet wird (Selbstabbildungsebene des Sendegitters 6), fällt somit vorteilhaft zusammen mit der Ebene, in welche die Detektoranordnung 5 fokussiert ist, während die Messmarke 1 außerhalb jener Ebene liegen kann.

Hiermit wird erreicht, dass die mindestens eine Messmarke 1 selbst nicht innerhalb der Abbildungsachse A liegen muss, so dass keine Gefahr der Kollision mit Komponenten bzw. Bauteilen besteht, welche im Betrieb einer zugehörigen Maschine in der Abbildungsebene A bewegt werden. Die Abbildungsachse 55 der Detektoranordnung 5 verläuft im Ausführungsbeispiel der Figur 1 parallel zur Strahlungsachse 45 der von der Strahlungsquelle 4 erzeugten (kollimierten) elektromagnetischen Strahlung.

Im Ergebnis erstrecken sich somit die Ebene E der mindestens einen Messmarke 1 sowie die Abbildungsebene A jeweils senkrecht zu der Strahlungsachse 45 der Strahlungsquelle 4 und der Abbildungsachse 55 der Detektoranordnung 5.

Ein Messmarkensystem der in Figur 1 dargestellten Art lässt sich bei Integration in eine zugeordnete Maschine, insbesondere einem Bestückungsautomaten, wie folgt betreiben, wobei im Betrieb der Maschine eine Bewegung der Abtasteinheit 3 bezüglich der Messmarke 1 entlang der y-Richtung (senkrecht zur Blattebene der Figur 1) erfolgen soll:
Die Strahlungsquelle 4 in Form einer Lichtquelle, welche insbesondere zur Erzeugung einer kollimierten elektromagnetischen Strahlung ausgeführt sein kann, bestrahlt das Sendegitter 6, das zusammen mit der Strahlungsquelle 4 und der Detektoranordnung 5 zu einer Abtasteinheit 3 zusammengefasst ist. Bei dem Sendegitter 6 kann es sich beispielsweise um ein Amplitudengitter handeln. Dessen Teilungsperiode kann in der Größenordnung von 20 µm liegen.

Im Ausführungsbeispiel verläuft die Richtung der Teilungsstriche des Sendegitters 6 senkrecht zur Messrichtung y, und dabei entlang der Richtung x, welche gemeinsam mit der Messrichtung y die Ebene E der mindestens einen Messmarke 1 bzw. die Abbildungsebene A der Detektoranordnung 5 aufspannt.

Nach der Wechselwirkung mit dem Sendegitter 6 trifft die von der Strahlungsquelle 4 ausgesandte elektromagnetische Strahlung auf die mindestens eine Messmarke 1. Diese kann ebenfalls als ein Gitter, z. B. als ein Transmissions-Phasengitter, mit einer Gitterperiode von 20 µm ausgeführt sein.

Die Messmarke 1 befindet sich bei bestimmungsgemäßer Anordnung des Messmarkensystems an einer Maschine, z. B. an einem Bestückungsautomaten, in der Nähe der mit der Maschine zu handhabenden und mit der Detektoranordnung 5 in Form einer Kamera zu erfassenden Werkstücke, dabei jedoch in einer anderen Höhe (entlang der axialen Richtung z betrachtet, welche sich senkrecht zur Ebene E der Messmarke 1 bzw. der Abbildungsebene A erstreckt).

Im Ausführungsbeispiel der Figur 1 wird die von der Strahlungsquelle 4 ausgesandte elektromagnetische Strahlung (nach der Wechselwirkung mit dem Sendegitter 6 und der mindestens einen Messmarke 1) durch das eingangsseitige, einkoppelnde Umlenkgitter 14 in x-Richtung abgelenkt. Die durch das eingangsseitige Umlenkgitter 14 abgelenkte Strahlung wird in dem Substrat 10 mehrfach an dessen Spiegelschichten 12 reflektiert und weist somit eine Komponente in x-Richtung auf; der Verlauf der Strahlung im Substrat 10 ist demnach zick-zack-förmig. Bei einem entsprechend großen Ablenkwinkel der Strahlung durch das eingangsseitige Umlenkgitter 14 könnte alternativ zu der Verwendung von Spiegelschichten auch Totalreflexionen der Strahlung an den Oberflächen des Substrates 10 genutzt werden.

Mit dem zweiten, ausgangsseitigen Umlenkgitter 16 wird die elektromagnetische Strahlung wieder aus dem Substrat 10 herausgeführt, und zwar entlang der Abbildungsachse 55 der Detektoranordnung 5, welche parallel zur Strahlungsachse 45 der Strahlungsquelle 4 verläuft. Die beiden Achsen 45, 55 sind als Ergebnis der Ablenkung der Strahlung durch die beiden Umlenkgitter 14, 16 entlang einer Richtung x voneinander beabstandet, welche quer zur Messrichtung y sowie quer zur Richtung z der Achsen 45, 55 (axiale Richtung) ausgerichtet ist.

Das transparente Substrat 10 hat im Ergebnis die optische Wirkung einer Planplatte mit einem Brechungsindex n und verursacht dadurch eine räumliche Versetzung der die virtuelle Messmarke 2 bildenden Selbstabbildung des Sendegitters 6 (in z-Richtung). Für eine relativ grobe Gitterkonstante von 20 µm ergibt sich dieser Versatz näherungsweise zu d*(n-1)/n, wobei d den geometrischen Weg (Zick-Zack-Weg) der Strahlung im Substrat 10 angibt.

Der Abstand zwischen der mindestens einen Messmarke 1 und der zugehörigen virtuellen Messmarke 2, welcher diesen Bildversatz berücksichtigt, wird auch als "effektiver Abstand" bezeichnet. Es handelt sich hierbei um den optischen Weg von der Messmarke 1 zur virtuellen Messmarke 2.

Im Fall der Figur 1 ist die Anordnung vorteilhaft derart, dass der effektive Abstand zwischen dem Sendegitter 6 und der Messmarke 1 (Abstand u) gleich dem effektiven Abstand zwischen der Messmarke 1 und der virtuellen Messmarke 2 (Abstand v) ist, also u/v = 1, wobei die Abstände u und v vorliegend nicht jeweils die kürzeste Strecke zwischen Sendegitter 6 und Messmarke 1 bzw. zwischen Messmarke 1 und virtueller Messmarke 2 bezeichnen sollen, sondern vielmehr, wie vorstehend erläutert, den optischen Weg der Strahlung zwischen Sendegitter 6 und Messmarke 1 bzw. Messmarke 1 und virtueller Messmarke 2.

Im Fall des Sendegitters 6 und der Messmarke 1 fällt dabei vorliegend der effektive Abstand u mit der kürzesten Strecke zusammen. Im Fall der Messmarke 1 und der virtuellen Messmarke 2 ist demgegenüber die Zick-Zack-Bewegung der Strahlung im Substrat 10 zu berücksichtigen, so dass der effektive Abstand v deutlich größer ist als die kürzeste Strecke zwischen der Messmarke 1 und der virtuellen Messmarke 2.

Die in der Abbildungsebene A der Detektoranordnung 5 erzeugte virtuelle Messmarke 2 wird mittels eines Objektivs 52 der Detektoranordnung 5 auf deren Sensorchip 50, z. B. in Form einer CCD-Zeile, abgebildet.

Bei einer Relativbewegung der Abtasteinheit 3 bezüglich der Messmarke 1 in Messrichtung y erfolgt eine Phasenverschiebung der Selbstabbildung des Sendegitters 6, welche die virtuelle Messmarke 2 bildet. Da thermisch bedingte Längenänderungen an einer Maschine, in welche das Messmarkensystem gemäß Figur 1 zu integrieren ist, in der Regel kleiner sind als die Teilungsperiode des abgebildeten Gitters, dient die Phasenlage des an der Detektoranordnung 5 detektierten Streifenmusters der Positionsdetektion innerhalb einer Teilungsperiode (an der gewählten Referenzposition der Maschine).

Bei der in Figur 1 dargestellten Ausführungsform eines Messmarkensystems kann eine ohnehin am Bestückungskopf eines Bestückungsautomaten vorgesehene Kamera zusätzlich als Bestandteil des Messmarkensystems verwendet werden. Eine Modifikation oder spezielle Anpassung der Kamera ist nicht erforderlich.

Beim Überfahren der Messmarke 1 durch die Abtasteinheit 3 wird jeweils kurzzeitig die Strahlungsquelle 4 aktiviert und somit eine Referenzpositionsmessung mittels des Messmarkensystems zu Zwecken einer Kalibrierung durchgeführt. Durch die nur selektive Betätigung der Strahlungsquelle 4 zu solchen Zeitpunkten, an denen eine Referenzpositionsmessung bzw. Kalibrierung erfolgen soll, wird vermieden, dass die Detektionsaufgaben der Detektoranordnung 5 während einer Bestückung von Platinen mit Bauteilen gestört werden könnten.

Die Pulsdauer T der Strahlungsquelle 4 kann dabei vorteilhaft in Abhängigkeit von der Verfahrgeschwindigkeit v der Abtasteinheit 3 und von der Signalperiode SP gemäß nachfolgender Beziehung gewählt werden: T < SP / (2 • v). Unter der Signalperiode SP wird dabei diejenige Länge verstanden, um die die Abtasteinheit 3 zu verschieben ist, damit das abgebildete Abtastmuster um eine Periode verschoben wird.

Das Abbildungsverhältnis bei der Selbstabbildung des Sendegitters 6 in die Abbildungsebene A ist dabei abhängig vom Verhältnis der effektiven (optischen) Abstände Sendegitter 6 zu Messmarke 1 einerseits und Messmarke 1 zu virtuelle Messmarke 2 andererseits. Wählt man dieses Verhältnis u/v zu 1, so ist im vorliegend relevanten Fall eines Beugungsbildes die Teilungsperiode des die virtuelle Messmarke 2 erzeugenden Bildes (unabhängig davon, ob es sich bei der verwendeten Strahlungsquelle um eine kollimierte Strahlungsquelle handelt oder nicht) genauso groß wie die Teilungsperiode des Sendegitters 6. Hiermit ist der Vorteil verbunden, dass sich bei einer Abstandsänderung der Abtasteinheit 3 relativ zur Messmarke 1 das Verhältnis der vorgenannten Abstände nicht ändert, also weiterhin eins beträgt und damit auch die Teilungsperiode der virtuellen Messmarke 2 weiterhin gleich der Teilungsperiode des Sendegitters 6 ist. Die Abtastung der Messmarke 1 ist somit abstandsunabhängig.

Da die räumliche Lage der Selbstabbildung des Sendegitters 6 durch Justage des Sendegitters 6 entlang der Strahlungsachse 45, also entlang der z-Richtung, so gewählt werden kann, dass sie mit der Fokusebene (Abbildungsebene) der Detektoranordnung 5 während der Bestückungsvorgänge der zugeordneten Maschine übereinstimmt, ist keine Refokussierung der Detektoranordnung 5 während einer Referenzpositionsmessung zu Zwecken der Kalibrierung erforderlich.

Wie beschrieben, wird beim Ausführungsbeispiel der Figur 1 mittels des transparenten Substrates 10 ein Versatz der von der Strahlungsquelle 4 in Richtung auf die Messmarke 1 abgestrahlten elektromagnetischen Strahlung erreicht, um eine geometrische Trennung der Strahlungsachse 45 der Strahlungsquelle 4 von der Abbildungsachse 55 sicherzustellen. Dies ermöglicht eine (kollisionsfreie) Anordnung der Strahlungsquelle 4 und des Sendegitters 6 neben der Detektoranordnung 5. Hierdurch kann eine an einem Bestückungskopf einer Maschine ohnehin vorgesehene Detektoranordnung, insbesondere in Form einer Kamera, ohne weitere Änderungen auch als Bestandteil des Messmarkensystems verwendet werden.

In einer in Figur 2 gezeigten Ausführungsform eines Messmarkensystems fallen demgegenüber die Strahlungsachse 45 und die Abbildungsachse 55 zusammen. Dies ermöglicht eine kleinere laterale Dimensionierung des Messmarkensystems; und die Notwendigkeit eines dicken Substrates, in welchem sich die zur Abtastung verwendete elektromagnetische Strahlung ausbreiten kann, um einen lateralen Versatz von Strahlungsachse und Abbildungsachse zu erreichen, entfällt.

Im Ausführungsbeispiel der Figur 2 wird dabei die Parallelität bzw. Kollinearität von Abbildungs- und Strahlungsachse durch die Verwendung eines Umlenkelementes 18 erreicht, welches zugleich einen Strahlungsteiler bildet. Die von der Strahlungsquelle ausgesandte elektromagnetische Strahlung wird (nach der Wechselwirkung mit einem Sendegitter 6) durch das Umlenkelement 18 derart umgelenkt, dass die Strahlungsachse 45 der umgelenkten elektromagnetischen Strahlung mit der Abbildungsachse 55 der Detektoranordnung 5 zusammenfällt. Hierzu liegt das Umlenkelement 18 im Ausführungsbeispiel der Figur 2 in dem durch die Abbildungsachse 55 definierten Strahlengang. Die von der Strahlungsquelle 4 ausgesandte elektromagnetische Strahlung wird dabei zunächst senkrecht zur Abbildungsachse 55 ausgestrahlt und dann durch das Umlenkelement 18 so umgelenkt, dass die Strahlungsachse 45 parallel bzw. kollinear zur Abbildungsachse 55 verläuft.

Die Verwendung eines zusätzlichen Umlenkelementes 18 in der Abtasteinheit 3 hat zur Folge, dass eine am Bestückungskopf einer Maschine ohnehin vorgesehene Kamera für den Einsatz in dem Messmarkensystem gemäß Figur 2 modifiziert oder hierfür eine weitere Kamera eingesetzt werden muss. So ist im Ausführungsbeispiel der Figur 2 das Umlenkelement 18 zwischen dem Objektiv 52 und dem Sensorchip 50 der Detektoranordnung 5 anzuordnen.

Die Messmarke 1 (in Form eines Messmarkengitters) kann in diesem Fall in einfacher Weise auf einem reflektierenden Substrat 10' angeordnet sein.

Für eine Referenzpositionsmessung (zu Zwecken der Kalibrierung) wird die von der Strahlungsquelle 4 ausgesandte elektromagnetische Strahlung (nach einer Wechselwirkung mit dem Sendegitter 6) durch das Umlenkelement 18 umgelenkt und mittels des Objektivs 52 skaliert in eine Ebene hinter dem Objektiv abgebildet, so dass dort eine Zwischenabbildung des Sendegitters 6 erzeugt wird. Die genaue Lage der Ebene der Zwischenabbildung sowie der Abbildungsmaßstab sind dabei vom Verhältnis der Brennweite des Objektivs 52 zum optischen Abstand des Sendegitters 6 vom Objektiv 52 abhängig. Im Falle eines Beugungsbildes ist der Abbildungsmaßstab in Abhängigkeit von der Teilungsperiode des Sendegitters 6 vorteilhaft so zu wählen, dass die Periode der Zwischenabbildung des Sendegitters 6 der Periode des Gitters der Messmarke 1 entspricht. Die Zwischenabbildung wechselwirkt dann mit der Messmarke 1 in gleicher Weise wie ein reales Gitter (mit gleicher Teilungsperiode), um im Ergebnis eine Selbstabbildung des Sendegitters 6 in der Abbildungsebene A der Detektoranordnung 5 zu erzeugen.

Im Allgemeinen müsste - wegen der Abhängigkeit der Skalierung des Zwischenbildes von dem optischen Abstand des Sendegitters 6 zum Objektiv 52 - das Objektiv 52 bei jeder Referenzpositionsmessung dementsprechend in die richtige Ebene fokussiert werden. In einer vorteilhaften Ausführungsform wählt man die Ebene des Zwischenbildes so, dass sie mit der Fokusebene der Kamera für das Abbilden von Bauelementen im Betrieb der zugeordneten Maschine zusammenfällt. In diesem Fall ist für eine Referenzpositionsmessung keine Re-Fokussierung der Kamera erforderlich. Wird die Messmarke 1, wie im Fall der Figur 2 bereits beschrieben, als ein Reflexionsgitter ausgeführt, so ist der Abstand der Messmarke 1 zum Zwischenbild des Sendegitters 6 stets genauso groß wie der Abstand der Messmarke 1 von der Ebene der Selbstabbildung des Sendegitters 6. Dementsprechend entstehen in jener Abbildungsebene A dann sowohl das Zwischenbild des Sendegitters 6 als auch dessen resultierende Selbstabbildung (nach Wechselwirkung der elektromagnetischen Strahlung mit der Messmarke 1).

Um die Selbstabbildung des Sendegitters 6 bzw. des Zwischenbildes des Sendegitters 6 wiederum auf die Detektoranordnung 5 abzubilden, wird der Abstand des Sensorchips 50 des Detektors 5 zum Objektiv 52 genauso groß gewählt wie der optische Abstand des Sendegitters 6 vom Objektiv 52.

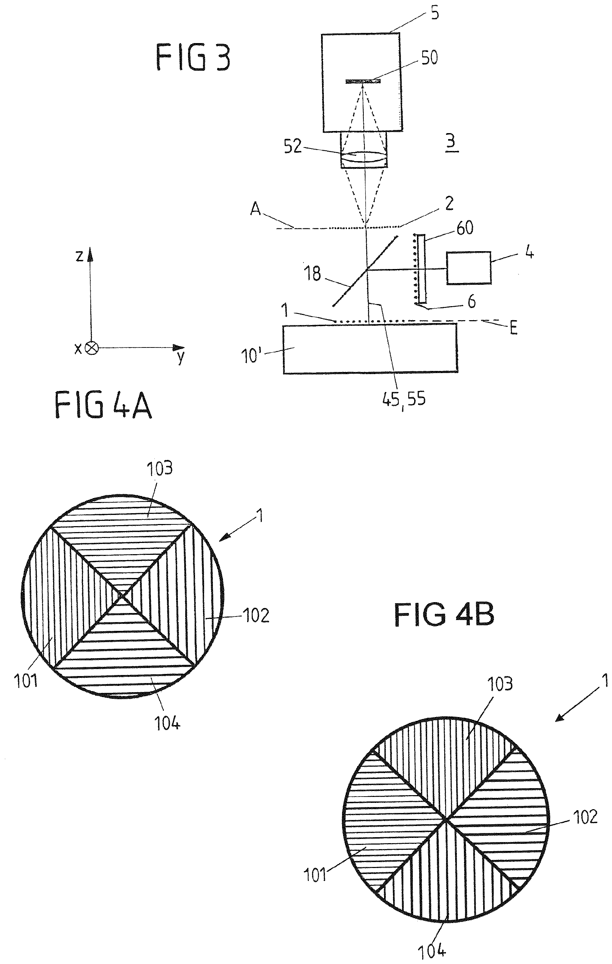

Figur 3 zeigt eine Abwandlung des Ausführungsbeispiels aus Figur 2, gemäß welcher das Umlenkelement 18 in Form eines Strahlteilers (zusammen mit der Strahlungsquelle 4 und dem Sendegitter 6) unterhalb der Fokusebene der Detektoranordnung 5 vorgesehen ist. Die Anordnung ist dabei derart, dass der Abstand des Sendegitters 6 vom Umlenkelement 18 gleich dem Abstand zwischen der Abbildungsebene A und dem Umlenkelement 18 ist.

Beim Ausführungsbeispiel der Figur 3 entfällt die Erzeugung einer Zwischenabbildung des Sendegitters 6.

Bei dieser Ausführungsform kann vorgesehen sein, dass die Messmarke 1 und die Strahlungsquelle 4 zusammen mit dem Sendegitter 6 eine Einheit bilden, um die einzelnen Abstandsbedingungen zu erfüllen. Es liegt dann eine stationäre Selbstabbildung des Sendegitters 6 vor; und dessen Abtastung durch die Detektoranordnung 5 im Zusammenspiel mit der Strahlungsquelle 4 ist nicht mehr abstandsunabhängig.

Insgesamt wurde das Messmarkensystem anhand der Ausführungsbeispiele der Figuren 1 bis 3 jeweils für eine Auflichtvariante bei der Erfassung der Messmarke(n) 1 beschrieben; hierbei kann jedoch auch eine Durchlichtvariante zur Anwendung kommen.

Für die Ausgestaltung der Messmarke 1 eines erfindungsgemäßen Messmarkensystems besteht eine Vielzahl unterschiedlicher Möglichkeiten. Im einfachsten Fall kann die Messmarke 1 durch ein periodisches Gitter gebildet werden, dessen Teilungsstriche in Messrichtung hintereinander angeordnet sind und die sich jeweils quer zur Messrichtung parallel zueinander erstrecken.

Gemäß einer Weiterbildung kann eine Messmarke entlang unterschiedlicher Raumrichtungen erstreckte Gitter umfassen, um eine Referenzpositionsmessung nicht nur in Messrichtung, sondern z. B. auch senkrecht hierzu vornehmen zu können und gegebenenfalls auch Verdrehungen erfassen zu können.

Auch kann eine Messmarke so ausgeführt sein, dass sie eine Absolutmessung von Positionsabweichungen ermöglicht. Dies lässt sich z. B. dadurch erreichen, dass zwei Gitter vorgesehen sind, die entlang derselben Richtung hintereinander angeordnete Teilungsstriche, jedoch mit unterschiedlichen Teilungsperioden, aufweisen.

Bei dem in Figur 4A dargestellten Ausführungsbeispiel umfasst die Messmarke 1 insgesamt vier Teilungsfelder 101, 102, 103, 104. Dabei sind die Teilungsstriche des ersten und zweiten Teilungsfeldes 101, 102 entlang derselben Raumrichtung hintereinander angeordnet, jedoch mit unterschiedlicher Teilungsperiode. Dies ermöglicht eine absolute Positionsbestimmung entlang jener Raumrichtung.

Die Teilungsstriche des dritten und vierten Teilungsfeldes 103, 104 sind ebenfalls jeweils entlang ein und derselben Raumrichtung hintereinander angeordnet, wobei diese senkrecht zur entsprechenden Raumrichtung der ersten Teilungsfelder 101, 102 verläuft - und dabei wiederum mit unterschiedlicher Teilungsperiode. Dies ermöglicht eine absolute Positionsmessung auch entlang jener zweiten Raumrichtung, senkrecht zur ersten Raumrichtung.

Eine Kombination von Teilungen, die Messungen entlang unterschiedlicher Raumrichtungen ermöglichen sollen, kann dabei - alternativ zu der Anordnung in unterschiedlichen Teilungsfeldern, wie im Fall der Figur 4A - auch in Form eines Kreuzgitters erfolgen.

Eine weitere Ausführungsform einer Messmarke ist in Figur 4B gezeigt. Die Teilungsstriche in den verschiedenen Teilungsfeldern 101, 102, 103, 104 der Messmarke 1 sind hierbei jeweils orthogonal zu denjenigen aus Figur 4A orientiert

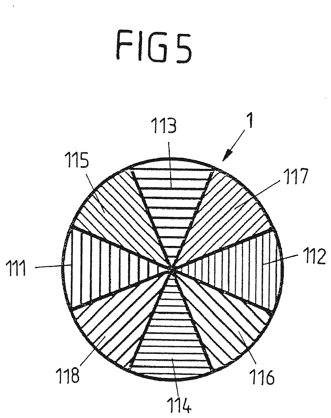

Beim Ausführungsbeispiel der Figur 5 sind insgesamt acht Teilungsfelder 111, 112, 113, 114, 115, 116, 117, 118 vorgesehen, welche eine Messmarke 1 bilden. Jeweils zwei der Teilungsfelder weisen dabei Teilungsstriche auf, die entlang derselben Raumrichtung (periodisch) hintereinander angeordnet sind, jedoch jeweils von Teilungsfeld zu Teilungsfeld mit unterschiedlicher Teilungsperiode. Dies ermöglicht eine absolute Positionsbestimmung entlang der jeweiligen Raumrichtung. Teilungsfelder, deren Teilungsstriche entlang derselben Raumrichtung hintereinander angeordnet sind, jedoch mit unterschiedlicher Teilungsperiode, sind dabei jeweils paarweise einander gegenüberliegend angeordnet, so die Teilungsfelder 111 und 112; die Teilungsfelder 113 und 114; die Teilungsfelder 115 und 116; sowie die Teilungsfelder 117 und 118.

Wegen der Anzahl Teilungsfelder mit räumlich unterschiedlich orientierten Gitterstrukturen können mit der Referenzmarke 1 gemäß Figur 5 nicht nur (absolute) Positionsbestimmungen entlang zweier zueinander senkrechter Richtungen in einer Ebene vorgenommen werden, sondern darüber hinaus auch noch Verdrehungen um eine Achse senkrecht zu jener Ebene detektiert werden.

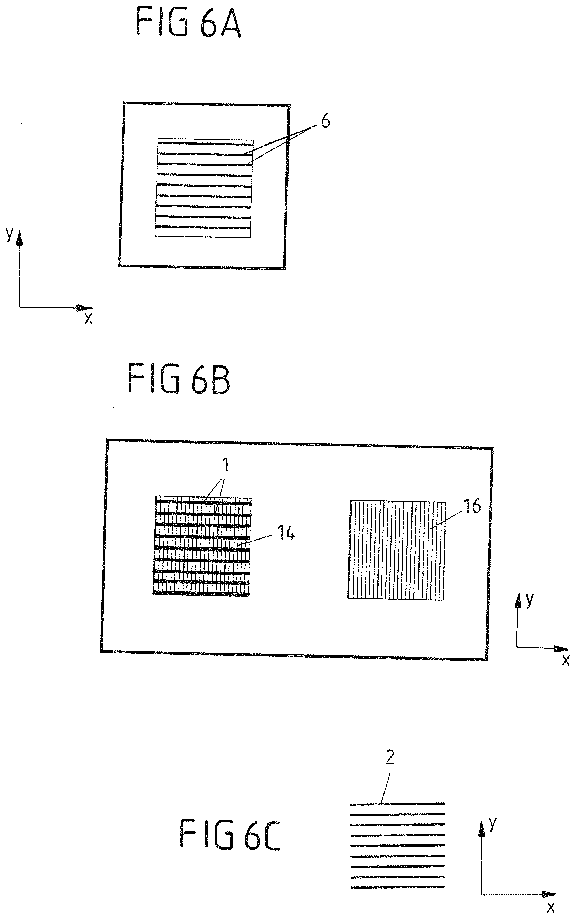

In den Figuren 6A, 6B und 6C sind speziell für das in Figur 1 gezeigte Messmarkensystem mögliche Ausführungsformen der relevanten Gitter dargestellt, nämlich das Sendegitter 6 in Figur 6A; die als periodisches Gitter ausgeführte Messmarke 1 in Figur 6B zusammen mit dem eingangsseitigen (einkoppelnden) Umlenkgitter 14 und dem ausgangsseitigen (auskoppelnden) Umlenkgitter 16; sowie das die virtuelle Messmarke 2 bildende Abbild des Sendegitters 6 in Figur 6C.

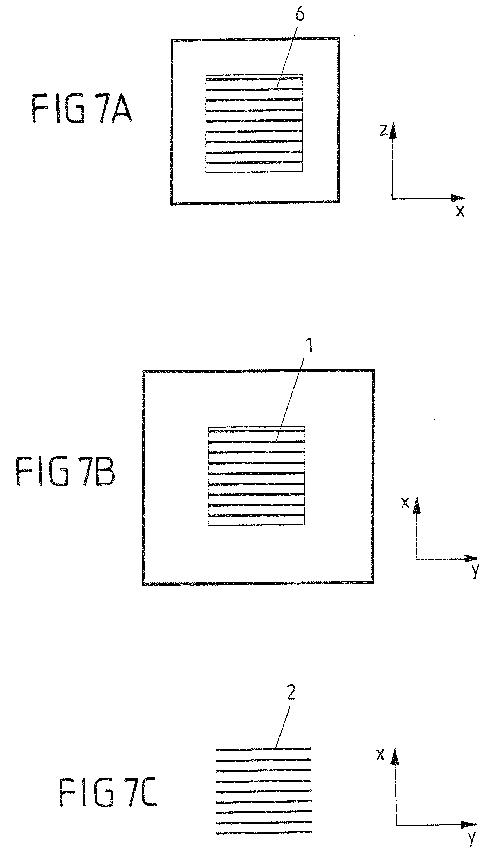

In entsprechender Weise zeigen die Figuren 7A bis 7C die relevanten Gitter bei einem Messmarkensystem der in Figur 2 dargestellten Art, nämlich das Sendegitter 6 in Figur 7A; die als periodisches Gitter ausgeführte Messmarke 1 in Figur 7B; sowie das die virtuelle Messmarke 2 bildende Selbstabbild des Sendegitters 6 in Figur 7C.

## Patentansprüche

1. Messmarkensystem zur Kalibrierung einer Maschine, die einen im Betrieb entlang mindestens einer Raumrichtung (y) verfahrbaren Maschinenkopf (S1) aufweist, mit
- mindestens einer Messmarke (1), die bestimmungsgemäß an der Maschine anzubringen ist, und
- einer Abtasteinheit (3) zur Erfassung der mindestens einen Messmarke (1) unter Verwendung elektromagnetischer Strahlung, wobei die Abtasteinheit (3) bestimmungsgemäß derart an der Maschine anzuordnen ist, dass sie gemeinsam mit dem Maschinenkopf (S1) relativ zu der Messmarke (1) verfahrbar ist und
- einer der Messmarke (1) zugeordneten Abbildungsoptik (6, 10, 10', 12, 14, 16, 18), um unter Wechselwirkung von der Abtasteinheit (3) erzeugter elektromagnetischer Strahlung mit der Messmarke (1) eine virtuelle Messmarke (2) in einer von der Messmarke (1) beabstandeten Abbildungsebene (A) zu erzeugen, wobei die Abtasteinheit (3) dazu eingerichtet ist, die virtuelle Messmarke (2) optisch abzutasten
und wobei die Abtasteinheit (3) eine elektromagnetische Strahlungsquelle (4) zur Bestrahlung der Messmarke (1) und eine Detektoranordnung (5) zur optischen Detektion der virtuellen Messmarke (2) umfasst,
**dadurch gekennzeichnet,**
- **dass** die mindestens eine Messmarke (1) zumindest abschnittsweise eine Gitterstruktur (101, 102; 103, 104; 111 bis 118) aufweist und
- **dass** die Abbildungsoptik (6, 10, 10', 12, 14, 16, 18) ein der Strahlungsquelle (4) nachgeordnetes und der Messmarke (1) vorgelagertes Sendegitter (6) umfasst, so dass die virtuelle Messmarke (2) in Form einer Selbstabbildung des Sendegitters (6) erzeugt wird.

2. Messmarkensystem nach Anspruch 1, **dadurch gekennzeichnet, dass** die Strahlungsquelle (4) zeitlich getaktet betreibbar ist.

3. Messmarkensystem nach Anspruch 1 oder 2, **dadurch gekennzeichnet, dass** die Detektoranordnung (5) durch eine Kamera gebildet wird, die ein Bestandteil der Positioniereinrichtung ist.

4. Messmarkensystem nach Anspruch 1, **dadurch gekennzeichnet, dass** der die optische Weglänge der elektromagnetischen Strahlung berücksichtigende effektive Abstand (u) zwischen dem Sendegitter (6) und der Messmarke (1) gleich dem effektiven Abstand (v) zwischen der Messmarke (1) und der virtuellen Messmarke (2) ist.

5. Messmarkensystem nach einem der Ansprüche 2 bis 4, **dadurch gekennzeichnet, dass** eine Strahlungsachse (45) der von der Strahlungsquelle (4) in Richtung auf die Messmarke (1) ausgesandten Strahlung parallel zu der Abbildungsachse (55) verläuft, entlang welcher die virtuelle Messmarke (2) auf die Detektoranordnung (5) abgebildet wird.

6. Messmarkensystem nach einem der vorhergehenden Ansprüche, **dadurch gekennzeichnet, dass** sich die mindestens eine Messmarke (1) entlang einer Messmarkenebene (E) erstreckt, die parallel zu der Abbildungsebene (A) verläuft und von dieser beabstandet ist.

7. Messmarkensystem nach Anspruch 5 und 6, **dadurch gekennzeichnet, dass** die Strahlungsachse (45) und die Abbildungsachse (55) senkrecht zu der Messmarkenebene (E) und der Abbildungsebene (A) ausgerichtet sind.

8. Messmarkensystem nach Anspruch 5 oder 7, **dadurch gekennzeichnet, dass** die Strahlungsachse (45) und die Abbildungsachse (55) voneinander beabstandet sind oder kollinear zusammenfallen.

9. Messmarkensystem nach einem der vorhergehenden Ansprüche, **dadurch gekennzeichnet, dass** die mindestens eine Messmarke (1) auf einem strahlungsdurchlässigen Substrat (10) angeordnet ist.

10. Messmarkensystem nach Anspruch 9, **dadurch gekennzeichnet, dass** das Substrat (10) abschnittsweise verspiegelt ist, so dass die von der Strahlungsquelle (4) ausgesandte elektromagnetische Strahlung nach der Wechselwirkung mit der Messmarke (1) in dem Substrat (10) reflektiert wird.

11. Messmarkensystem nach Anspruch 9 oder 10, **dadurch gekennzeichnet, dass** an dem Substrat (10) ein Umlenkgitter (14) zum Einkoppeln elektromagnetischer Strahlung in das Substrat (10) und ein Umlenkgitter (16) zum Auskoppeln elektromagnetischer Strahlung vorgesehen sind, um hieraus in der Abbildungsebene (A) die virtuelle Messmarke (2) zu erzeugen.

12. Messmarkensystem nach einem der Ansprüche 1 bis 8, **dadurch gekennzeichnet, dass** die Messmarke (1) auf einem reflektierenden Substrat (10') angeordnet ist, so dass die von der Strahlungsquelle (4) ausgesandte und mit der Messmarke (1) wechselwirkende elektromagnetische Strahlung zur Erzeugung der virtuellen Messmarke (2) von dem Substrat (10') zurückgeworfen wird.

## Claims

1. Measurement marker system for calibrating a machine which has a machine head (S1) that is displaceable along at least one spatial direction (y) during operation, said measurement marker system comprising
- at least one measurement marker (1) which is intended to be attached to the machine, and
- a scanning unit (3) for capturing the at least one measurement marker (1) using electromagnetic radiation, wherein the intention is for the scanning unit (3) to be arranged on the machine in such a way that it is displaceable relative to the measurement marker (1) together with the machine head (S1), and
- an imaging optical unit (6, 10, 10', 12, 14, 16, 18) assigned to the measurement marker (1) in order to produce a virtual measurement marker (2) in an imaging plane (A) spaced apart from the measurement marker (1) when the electromagnetic radiation produced by the scanning unit (3) interacts with the measurement marker (1),
wherein
the scanning unit (3) is configured to optically scan the virtual measurement marker (2),
and wherein the scanning unit (3) comprises an electromagnetic radiation source (4) for irradiating the measurement marker (1) and a detector arrangement (5) for optical detection of the virtual measurement marker (2),
**characterized**
- **in that** the at least one measurement marker (1) has, at least in portions, a grating structure (101, 102; 103, 104; 111 to 118) and
- **in that** the imaging optical unit (6, 10, 10', 12, 14, 16, 18) comprises a transmission grating (6) disposed downstream of the radiation source (4) and upstream of the measurement marker (1) such that the virtual measurement marker (2) is produced in the form of a self-image of the transmission grating (6) .

2. Measurement marker system according to Claim 1, **characterized in that** the radiation source (4) is operable in temporally clocked fashion.

3. Measurement marker system according to Claim 1 or 2, **characterized in that** the detector arrangement (5) is formed by a camera that is a constituent part of the positioning device.

4. Measurement marker system according to Claim 1, **characterized in that** the effective distance (u) between the transmission grating (6) and the measurement marker (1), which takes account of the optical path length of the electromagnetic radiation, equals the effective distance (v) between the measurement marker (1) and the virtual measurement marker (2).

5. Measurement marker system according to any one of Claims 2 to 4, **characterized in that** a radiation axis (45) of the radiation emitted from the radiation source (4) in the direction of the measurement marker (1) extends parallel to the imaging axis (55) along which the virtual measurement marker (2) is imaged onto the detector arrangement (5).

6. Measurement marker system according to any one of the preceding claims, **characterized in that** the at least one measurement marker (1) extends along a measurement marker plane (E), which extends parallel to the imaging plane (A) and which is spaced apart from the latter.

7. Measurement marker system according to Claims 5 and 6, **characterized in that** the radiation axis (45) and the imaging axis (55) are aligned perpendicular to the measurement marker plane (E) and the imaging plane (A).

8. Measurement marker system according to Claim 5 or 7, **characterized in that** the radiation axis (45) and the imaging axis (55) are spaced apart from one another or coincide in collinear fashion.

9. Measurement marker system according to any one of the preceding claims, **characterized in that** the at least one measurement marker (1) is arranged on a radiation-transmissive substrate (10).

10. Measurement marker system according to Claim 9, **characterized in that** the substrate (10) is mirrored in portions such that the electromagnetic radiation emitted by the radiation source (4) is reflected in the substrate (10) after the interaction with the measurement marker (1).

11. Measurement marker system according to Claim 9 or 10, **characterized in that** a deflection grating (14) for coupling electromagnetic radiation into the substrate (10) and a deflection grating (16) for output coupling electromagnetic radiation are provided on the substrate (10) in order to produce the virtual measurement marker (2) in the imaging plane (A) therefrom.

12. Measurement marker system according to any one of Claims 1 to 8, **characterized in that** the measurement marker (1) is arranged on a reflecting substrate (10') such that the electromagnetic radiation that is emitted by the radiation source (4) and that interacts with the measurement marker (1) is cast back by the substrate (10') for the purpose of producing the virtual measurement marker (2).

## Revendications

1. Système de repère de mesure destiné à l'étalonnage d'une machine, qui possède une tête de machine (S1) pouvant, en fonctionnement, être déplacée le long d'au moins une direction dans l'espace (y), comprenant
- au moins un repère de mesure (1) qui doit être monté sur la machine conformément à sa destination, et
- une unité de palpage (3) destinée à détecter l'au moins un repère de mesure (1) en utilisant un rayonnement électromagnétique, l'unité de palpage (3) devant être disposée sur la machine conformément à sa destination de telle sorte qu'elle puisse être déplacée par rapport au repère de mesure (1) conjointement avec la tête de machine (S1) et
- une optique de représentation (6, 10, 10', 12, 14, 16, 18) associée au repère de mesure (1) afin de générer, par interaction du rayonnement électromagnétique généré par l'unité de palpage (3) avec le repère de mesure (1), un repère de mesure virtuel (2) dans un plan de représentation (A) espacé du repère de mesure (1), l'unité de palpage (3) étant conçue pour palper optiquement le repère de mesure virtuel (2)
et l'unité de palpage (3) comportant une source de rayonnement (4) électromagnétique destinée à irradier le repère de mesure (1) et un arrangement détecteur (5) destiné à la détection optique du repère de mesure virtuel (2),
**caractérisé en ce**
- **que** l'au moins un repère de mesure (1) possède au moins dans certaines sections une structure de grille (101, 102 ; 103, 104 ; 111 à 118) et
- **que** l'optique de représentation (6, 10, 10', 12, 14, 16, 18) comporte une grille d'émission (6) disposée en amont de la source de rayonnement (4) et du repère de mesure (1), de sorte que le repère de mesure virtuel (2) est généré sous la forme d'une autoreprésentation de la grille d'émission (6).

2. Système de repère de mesure selon la revendication 1, **caractérisé en ce que** la source de rayonnement (4) peut fonctionner de manière cadencée dans le temps.

3. Système de repère de mesure selon la revendication 1 ou 2, **caractérisé en ce que** l'arrangement détecteur (5) est formé par une caméra qui est un élément constitutif du dispositif de positionnement.

4. Système de repère de mesure selon la revendication 1, **caractérisé en ce que** l'écart effectif (u) entre la grille d'émission (6) et le repère de mesure (1), qui tient compte de la longueur du trajet optique du rayonnement électromagnétique, est égal à l'écart effectif (v) entre le repère de mesure (1) et le repère de mesure virtuel (2).

5. Système de repère de mesure selon l'une des revendications 2 à 4, **caractérisé en ce qu'**un axe de rayonnement (45) du rayonnement émis par la source de rayonnement (4) en direction du repère de mesure (1) court parallèlement à l'axe de représentation (55) le long duquel le repère de mesure virtuel (2) est représenté sur l'arrangement détecteur (5).

6. Système de repère de mesure selon l'une des revendications précédentes, **caractérisé en ce que** l'au moins un repère de mesure (1) s'étend le long d'un plan de repère de mesure (E) qui court parallèlement au plan de représentation (A) et est espacé de celui-ci.

7. Système de repère de mesure selon les revendications 5 et 6, **caractérisé en ce que** l'axe de rayonnement (45) et l'axe de représentation (55) sont orientés perpendiculairement au plan de repère de mesure (E) et au plan de représentation (A).

8. Système de repère de mesure selon la revendication 5 ou 7, **caractérisé en ce que** l'axe de rayonnement (45) et l'axe de représentation (55) sont espacés l'un de l'autre ou coïncident de façon colinéaire.

9. Système de repère de mesure selon l'une des revendications précédentes, **caractérisé en ce que** l'au moins un repère de mesure (1) est disposé sur un substrat (10) laissant passer le rayonnement.

10. Système de repère de mesure selon la revendication 9, **caractérisé en ce que** le substrat (10) est métallisé dans certaines portions, de sorte que le rayonnement électromagnétique émis par la source de rayonnement (4) est réfléchi dans le substrat (10) après l'interaction avec le repère de mesure (1).

11. Système de repère de mesure selon la revendication 9 ou 10, **caractérisé en ce qu'**une grille de déviation (14) destinée à injecter le rayonnement électromagnétique dans le substrat (10) et une grille de déviation (16) destinée à découpler le rayonnement électromagnétique se trouvent sur le substrat (10) afin de générer à partir de celles-ci le repère de mesure virtuel (2) dans le plan de représentation (A).

12. Système de repère de mesure selon l'une des revendications 1 à 8, **caractérisé en ce que** le repère de mesure (1) est disposé sur un substrat réfléchissant (10'), de sorte que le rayonnement électromagnétique émis par la source de rayonnement (4) et interagissant avec le repère de mesure (1) est rejeté par le substrat (10') en vue de générer le repère de mesure virtuel (2).
